(19) Europäisches Patentamt / European Patent Office / Office européen des brevets

(11) **EP 3 453 108 B1**

(12) **EUROPÄISCHE PATENTSCHRIFT**

(45) Veröffentlichungstag und Bekanntmachung des Hinweises auf die Patenterteilung:
**15.09.2021 Patentblatt 2021/37**

(21) Anmeldenummer: **17716487.8**

(22) Anmeldetag: **03.04.2017**

(51) Int Cl.:
**H02P 6/28** (2016.01)  **H02P 9/48** (2006.01)

(86) Internationale Anmeldenummer:
**PCT/EP2017/057807**

(87) Internationale Veröffentlichungsnummer:
**WO 2017/190898 (09.11.2017 Gazette 2017/45)**

(54) **VERFAHREN ZUR ERMITTLUNG DER PHASENSTRÖME EINER ELEKTRISCHEN MASCHINE MIT EINEM STROMRICHTER**

METHOD FOR DETERMINING THE PHASE CURRENTS OF AN ELECTRIC MACHINE HAVING A CONVERTER

PROCÉDÉ DE DÉTERMINATION DES COURANTS DE PHASE D'UNE MACHINE ÉLECTRIQUE DOTÉE D'UN CONVERTISSEUR DE COURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.05.2016 DE 102016207690**

(43) Veröffentlichungstag der Anmeldung:
**13.03.2019 Patentblatt 2019/11**

(73) Patentinhaber:
• **Robert Bosch GmbH**
  **70442 Stuttgart (DE)**
• **SEG Automotive Germany GmbH**
  **70499 Stuttgart (DE)**

(72) Erfinder:
• **M S, Arunkumar**
  **70806 Kornwestheim (DE)**
• **ROESNER, Julian**
  **74199 Untergruppenbach (DE)**

(74) Vertreter: **Steinbauer, Florian et al**
**Dehns Germany**
**Theresienstraße 6-8**
**80333 München (DE)**

(56) Entgegenhaltungen:
**WO-A2-2014/044526      US-B1- 9 225 264**

• **CHAKRABARTI S ET AL: "A current reconstruction algorithm for three-phase inverters using integrated current sensors in the low-side switches", CONFERENCE RECORD OF THE 2003 IEEE INDUSTRY APPLICATIONS CONFERENCE. 38TH. IAS ANNUAL MEETING . SALT LAKE CITY, UT, OCT. 12 - 16, 2003; [CONFERENCE RECORD OF THE IEEE INDUSTRY APPLICATIONS CONFERENCE. IAS ANNUAL MEETING], NEW YORK, NY : IEEE, US, Bd. 2, 12. Oktober 2003 (2003-10-12), Seiten 925-932, XP010676127, DOI: 10.1109/IAS.2003.1257646 ISBN: 978-0-7803-7883-4**

**Beschreibung**

Die vorliegende Erfindung betrifft ein Verfahren zur Ermittlung der Phasenströme einer elektrischen Maschine mit einem Stromrichter sowie eine Recheneinheit zur Durchführung des Verfahrens.

Stand der Technik

Generatoren zur Umwandlung mechanischer Energie in elektrische Energie sind bekannt. In Kraftfahrzeugen werden in der Regel Klauenpolgeneratoren verwendet. Diese können mit elektrischer Erregung ausgestattet sein. Da Klauenpolgeneratoren Drehstrom erzeugen, ist für die in Kraftfahrzeugen üblichen Gleichspannungsbordnetze eine Gleichrichtung erforderlich. Hierzu können Gleichrichter mit Halbleiterdioden und/oder aktiven Schaltelementen verwendet werden.

Generatoren, die auch zum Fahrzeugantrieb eingesetzt werden, sind aus dem Bereich der Hybridfahrzeuge bekannt. Diese sollen den Verbrennungsmotor insbesondere dann, wenn dieser (noch) nicht sein volles Drehmoment liefert, unterstützen (Boostbetrieb, Turboloch-Kompensation). Motorisch betreibbare Generatoren mit ihren zugehörigen Wechselrichtern werden im Rahmen dieser Anmeldung auch als elektrische Antriebe bezeichnet.

Die Regelung eines elektrischen Antriebs kann mittels einer feldorientierten Regelung erfolgen, bei der die Phasenströme (d.h. Ströme durch die Phasen bzw. Ständerwicklungsstränge) der Maschine ermittelt und auf einen Sollwert geregelt werden. Bei dreiphasigen Maschinen werden dabei üblicherweise zwei Phasenströme gemessen, der dritte Phasenstrom kann rechnerisch ermittelt werden, da die Summe aller Phasenströme Null beträgt.

Entsprechend müssen bei Antrieben mit mehr als drei Phasen N - 1 Phasenströme gemessen werden, wobei N die Phasenzahl des Antriebs ist.

Für die feldorientierte Regelung werden die gemessenen Phasenströme in ein drehfeldfestes $dq$-Koordinatensystem transformiert. Für die Regelung sind nicht die einzelnen Phasenströme von Bedeutung, sondern der berechnete Stromvektor in dem $dq$-Koordinatensystem. Alle Phasenströme müssen jedoch bekannt oder zumindest rechnerisch ermittelbar sein.

Die Messung der Phasenströme kann über Messwiderstände, sogenannte Shunts, erfolgen. In der Regel sind diese Shunts nicht direkt in den Phasen des Antriebs verbaut, sondern in einem Lowside-Pfad des Stromrichters. Daher ist eine Messung nur zu den Zeitpunkten möglich, zu denen der zu messende Phasenstrom negativ ist, weil nur dann die im Lowside-Pfad des Stromrichters angeordneten Dioden oder aktiven Schaltelemente leiten. Es existieren daher, abhängig von der Ansteuerung (insbesondere PWM- oder Blockbetrieb) des Stromrichters, nur wenige, fest definierte Zeitpunkte, zu denen eine Strommessung erfolgen kann. Dies ist nicht zufriedenstellend.

Da für die Strommessung eine bestimmte Mindestzeit benötigt wird, die sich im Wesentlichen aus einer Einschwingzeit der Ständerspulen und den jeweiligen Messzeiten für die Strommessung der Messphasen ergeben, stoßen die bekannten Verfahren an ihre Grenzen, insbesondere dann, wenn der Aussteuerungsgrad sehr groß ist und die Zeitdauer der angesteuerten Lowside-Pfade geringer ist als die für die Strommessung benötigte Zeitdauer. Im Übrigen werden die zur Strommessung erforderlichen Strommessfenster durch die jeweiligen Schaltvorgänge der bei einer aktiven Gleichrichtung verwendeten Highside-Schalter und Lowside-Schalter weiter begrenzt, da bei jedem Einschalt- und Ausschaltvorgang Potentialdifferenzen erzeugt werden, die zu Schwankungen im Phasenstrom führen. Diese Schwankungen sind typischerweise nicht auf einzelne Phasen beschränkt, da die Phasen in der Regel untereinander gekoppelt sind.

Die Bereitstellung von Messwiderständen mit der erforderlichen Messelektronik ist zudem aufwendig, so dass vereinfachte Vorrichtungen und Verfahren zur Ermittlung der Phasenströme wünschenswert sind. Insbesondere besteht der Bedarf nach derartigen vereinfachten Vorrichtungen und Verfahren, die sich sowohl im PWM- als auch im Blockbetrieb verwenden lassen.

Aus der DE 102012217116 ist ein Verfahren bekannt, bei dem eine Anzahl von Phasenströmen einzelner Phasen gemessen, und die Phasenströme der verbleibenden Phasen auf Basis der gemessenen Phasenströme rechnerisch ermittelt werden.

Aus dem Konferenzbeitrag mit dem Titel "A current reconstruction algorithm for three-phase inverters using integrated current sensors in the low-side switches" (Chakrabarti et al., IEEE 2003, S. 925-932) ist ein Algorithmus bekannt, bei dem ein Teil der Phasenströme in einem Inverter auf Basis von komplexen Vektorberechnungen aus gemessenen Phasenströmen im Low-Side-Pfad rekonstruiert wird.

Offenbarung der Erfindung

Erfindungsgemäß werden ein Verfahren zur Ermittlung der Phasenströme einer elektrischen Maschine mit einem Stromrichter und einem Ständer umfassend Ständerwicklungen mit einer Phasenzahl von zumindest drei sowie eine Recheneinheit zu dessen Durchführung mit den Merkmalen der unabhängigen Patentansprüche vorgeschlagen.

Vorteilhafte Ausgestaltungen sind jeweils Gegenstand der Unteransprüche sowie der nachfolgenden Beschreibung.

Vorteile der Erfindung

Das erfindungsgemäße Verfahren umfasst, die Phasenströme einer Anzahl von Messphasen, die zumindest zwei beträgt, zu messen, und die Phasenströme der übrigen Phasen dann rechnerisch aus den bezüglich der Messphasen gemessenen Phasenströmen zu bestimmen. Damit können der Messaufwand wesentlich reduziert und/oder die Zeitspannen, zu denen gemessen werden kann, erhöht werden. Die Phasenströme der Messphasen werden hierbei in einem Messintervall erfasst, wobei das Messintervall seinerseits innerhalb eines Schaltintervalls der den Messphasen zugeordneten aktiven Schaltelemente in einem Lowside-Pfad liegt. Das Schaltintervall weist hierbei Einschaltzeitpunkte und Ausschaltzeitpunkte auf. Die Phasenströme werden somit während einer aktiven Beschaltung der jeweiligen Lowside-Pfade ermittelt.

Zur rechnerischen Bestimmung der übrigen Phasenströme werden insbesondere die gemessenen Phasenströme in Betrag und Phasenlage sowie der räumliche Winkel der einzelnen Ständerwicklungsstränge bzw. der räumliche Winkelversatz der einzelnen Ständerwicklungsstränge zueinander verwendet.

Im Rahmen der vorliegenden Anmeldung wird mit "Phasenzahl" die Gesamtanzahl der Phasen (Ständerwicklungsstränge) der elektrischen Maschine bezeichnet. Bei einer elektrischen Maschine mit fünf Ständerwicklungssträngen beträgt diese also fünf. Als "Messphasen" werden im Rahmen der vorliegenden Erfindung jene Phasen der elektrischen Maschine bezeichnet, deren Phasenströme tatsächlich über entsprechende Messeinrichtungen, beispielsweise Messwiderstände, gemessen werden. Die Messphasen müssen nicht notwendigerweise festgelegt sein, es kann sich auch beispielsweise um jene Phasen handeln, die in einem bestimmten Schaltzustand messbar sind. Diese weisen jedoch entweder einzeln oder auch beispielsweise paarweise geeignete Messeinrichtungen auf. Die Phasenströme der "übrigen Phasen" werden zumindest in dem jeweils betrachteten Mess- bzw. Schaltzyklus nicht gemessen. Damit ergibt sich durch Addition der Anzahl der Messphasen und der Anzahl der übrigen Phasen die Phasenzahl.

Die Genauigkeit und Reproduzierbarkeit der Phasenströme der Messphasen und die Genauigkeit und Reproduzierbarkeit der hieraus ermittelten übrigen Phasenströme hängt zudem maßgeblich davon ab, dass, vorzugsweise für jeden Schaltzyklus, das Messintervall, in dem die Phasenströme der Messphasen bestimmt werden, derart gewählt wird, dass zum einen die für die Bestimmung aller Phasenströme erforderlichen Phasenströme der Messphasen ermittelt werden können und zum anderen das Messintervall zeitlich derart positioniert ist, dass die Messungen der Phasenströme nicht durch die Beschaltung der aktiven Schaltelemente und der damit verbundenen Potentialschwankungen beeinflusst werden. Dies wird erfindungsgemäß dadurch erreicht, dass das Messintervall zeitlich stets außerhalb der Einschaltzeitpunkte oder der Ausschaltzeitpunkte der den Phasen des Ständers zugeordneten aktiven Schaltelemente liegt. Es gibt demnach keine zeitliche Überlappung.

Das Messintervall weist vorzugsweise eine Mindestdauer auf, die im Wesentlichen durch eine Einschwingzeit zumindest einer der Ständerwicklungen und der Messzeiten, die für eine Erfassung der jeweiligen Phasenströme der einzelnen Messphasen erforderlich ist, gegeben ist. Hierdurch kann sichergestellt werden, dass sich das Gesamtsystem der Phasenwicklungen in einem Gleichgewichtszustand befindet und die aus den Phasenströmen der Messphasen abgeleiteten weiteren Phasenströme exakt ermittelbar sind.

Zudem ist es weiter bevorzugt, dass während eines Messintervalls weder die aktiven Schaltelemente eines Highside-Pfades noch die aktiven Schaltelemente eines Lowside-Pfades beschaltet werden. Hierdurch kann sichergestellt werden, dass die durch die Potentialschwankungen bewirkten Schwankungen im Phasenstrom abgeklungen sind und das Abwarten einer erneuten Einschwingzeit der Ständerwicklungen zur Vornahme einer Messung der jeweiligen Phasenströme nicht erforderlich ist.

In einer weiteren Ausgestaltung der Erfindung ist es bevorzugt, dass die Einschaltzeitpunkte und die Ausschaltzeitpunkte erfasst und in zeitlicher Reihenfolge sortiert werden, wobei die Zeitdifferenz zwischen einem Einschaltzeitpunkt oder einem Ausschaltzeitpunkt und dem direkt benachbarten Einschaltzeitpunkt oder Ausschaltzeitpunkt erfasst und mit dem Messintervall, insbesondere mit der zeitlichen Dauer des Messintervalls, verglichen wird. Es ist weiter bevorzugt, dass die Zeitdifferenz(en) identifiziert wird bzw. werden deren zeitliche Dauer zumindest der Zeitdauer des Messintervalls entspricht. Grundsätzlich liegen die potentiell nutzbaren Messfenster zur Ermittlung eines Phasenstroms zwischen den Schaltpulsen der aktiven Schaltelemente. Durch Ermittlung der Zeitdifferenz zwischen den Schaltpulsen und dem Vergleich dieser Zeitdifferenz mit dem für eine Messung erforderlichen Messintervall können die Zeitbereiche innerhalb eines Zyklus identifiziert werden, an denen eine Messung der Phasenströme möglichst vieler Phasen gewährleistbar ist.

In einer weiteren bevorzugten Ausgestaltung der Erfindung wird das Messintervall derart gewählt und zeitlich zwischen den jeweiligen Einschaltzeitpunkten oder Ausschaltzeitpunkten angeordnet, dass innerhalb des Messintervalls zumindest zwei Phasenströme, vorzugsweise eine größtmögliche Anzahl von Phasen strömen, gemessen werden können. Durch die Messung von mehr als zwei Phasenströmen, kann die rechnerische Ermittlung der weiteren Phasenströme exakter durchgeführt werden. Zudem kann im Rahmen des erfindungsgemäßen Verfahrens vorgesehen sein innerhalb der potentiellen Messfenster die Anzahl der möglichen Phasenstrommessungen zu ermitteln, die innerhalb eines Messintervalls messbar sind. Somit kann das Messfenster ausgewählt werden, dass eine größtmögliche Anzahl von Phasenstrommessungen zulässt, wodurch entsprechend die rechnerisch ermittelten Phasenströme exakter bestimmbar sind.

Wie eingangs erläutert, müssen in herkömmlichen Verfahren bei elektrischen Maschinen mit mehr als drei Phasen N - 1 Phasenströme gemessen werden, d.h. die Anzahl der Messphasen beträgt N-1 und die Anzahl der übrigen Phasen beträgt 1. Erfindungsgemäß genügt hingegen zur Ermittlung aller Phasenströme im einfachsten Fall die Messung der Phasenströme nur zweier Messphasen, die Phasenströme der übrigen Phasen lassen sich hieraus rechnerisch bestimmen.

Für die erfindungsgemäße Ermittlung der Phasenströme ist eine elektrische Maschine mit einer Phasenzahl von drei erforderlich. Die der Erfindung zugrunde liegenden Vorteile ergeben sich insbesondere für elektrische Maschinen mit einer Phasenzahl von vier und mehr Phasen, und eignet sich daher in besonderer Weise für derartige elektrische Maschinen. Die Erfindung eignet sich in besonderer Weise für elektrische Maschinen mit Stromrichtern, die in sogenannten Boostrekuperationssystemen bei Kraftfahrzeugen zum Einsatz kommen.

Das erfindungsmäße Verfahren kann durch eine mess- und auswertetechnisch vorteilhafte Auswahl der jeweils zu messenden Phasen sowie der Strommesszeitpunkte in Abhängigkeit vom jeweils gewählten Ansteuermuster ergänzt werden. Die Erfindung kann auch eine Messung entsprechender Phasenströme in einer gemeinsamen Leitung, an die mehrere Phasen angebunden sind, umfassen, so dass sich die Auswertung deutlich einfacher gestaltet als im Stand der Technik. Der Strom in der gemeinsamen Leitung ergibt sich demnach als Summenstrom der einzelnen Phasenströme. Gleichzeitig kann durch die vorgeschlagenen Maßnahmen sowohl bei PWM- als auch bei Blockansteuerung zu sehr vielen Zeitpunkten ein gültiger Stromvektor im $dq$-Koordinatensystem ermittelt werden.

Ein wesentlicher Vorteil der Erfindung ist damit insbesondere eine Einsparung von Strommesseinrichtungen im Antrieb und damit eine Reduzierung der Baugröße und der Herstellungskosten einerseits und eine Ausweitung möglicher Messzeitpunkte andererseits.

Eine erfindungsgemäße Recheneinheit, z.B. ein Ladesteuergerät eines Kraftfahrzeugs, ist, insbesondere programmtechnisch, dazu eingerichtet, ein erfindungsgemäßes Verfahren durchzuführen.

Auch die Implementierung des Verfahrens in Form von Software ist vorteilhaft, da dies besonders geringe Kosten verursacht, insbesondere wenn ein ausführendes Steuergerät noch für weitere Aufgaben genutzt wird und daher ohnehin vorhanden ist. Geeignete Datenträger zur Bereitstellung des Computerprogramms sind insbesondere Disketten, Festplatten, Flash-Speicher, EEPROMs, CD-ROMs, DVDs u.a.m. Auch ein Download eines Programms über Computernetze (Internet, Intranet usw.) ist möglich.

Weitere Vorteile und Ausgestaltungen der Erfindung ergeben sich aus der Beschreibung und der beiliegenden Zeichnung.

Die Erfindung ist anhand eines Ausführungsbeispiels/von Ausführungsbeispielen in der Zeichnung schematisch dargestellt und wird im Folgenden unter Bezugnahme auf die Zeichnung ausführlich beschrieben.

Kurze Beschreibung der Zeichnungen

Figur 1 zeigt eine elektrische Maschine mit einem Stromrichter, wie sie der Erfindung zugrunde liegen kann, in schematischer Darstellung.

Figur 2 zeigt ein PWM-Ansteuerschema für eine elektrische Maschine mit einem Stromrichter gemäß Figur 1 und eine Ermittlung der Phasenströme gemäß dem Stand der Technik in schematischer Darstellung.

Figur 3 zeigt ein PWM-Ansteuerschema für eine elektrische Maschine mit einem Stromrichter gemäß Figur 1 und einer erfindungsgemäßen Ermittlung von Phasenströmen in schematischer Darstellung

Figur 4 zeigt eine zeitliche Überlagerung eines PWM-Ansteuerschemas für eine elektrische Maschine mit einem Stromrichter gemäß Figur 1 und eine Erfindungsgemäße Ermittlung eines Messintervalls zur Messung von Phasenströmen in schematischer Darstellung

Ausführungsform(en) der Erfindung

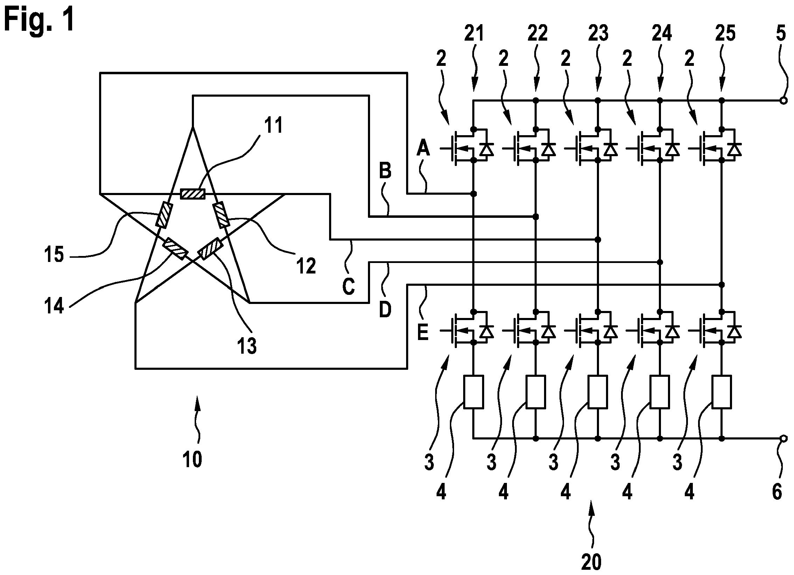

Figur 1 zeigt die zur Veranschaulichung der Erfindung wesentlichen Elemente einer elektrischen Maschine mit einem Stromrichter in stark vereinfachter Darstellung, wie sie Teil eines Kraftfahrzeugbordnetzes sein kann. Hiervon umfasst ist ein fünfphasiger Ständer (bzw. Stator) 10. Der fünfphasige Ständer 10 weist insgesamt fünf Ständerwicklungsstränge (auch als Statorwicklungen bezeichnet) 11 bis 15 auf. Ein Läufer (bzw. Rotor) ist der Übersichtlichkeit halber nicht dargestellt.

Der fünfphasige Ständer 10 ist mit seinen fünf Ständerwicklungssträngen 11 bis 15 an einen Stromrichter 2 angebunden, der fünf Stromrichterbrücken 21 bis 25 mit aktiven Schaltelementen 2, 3, beispielsweise MOSFETs, aufweist. Die fünf Ständerwicklungsstränge 11 bis 15 bzw. die fünf Stromrichterbrücken 21 bis 25 definieren die fünf Phasen A bis E der elektrischen Maschine. Der Stromrichter 2 kann als Gleichrichter (üblicherweise bei einem generatorischen Betrieb der elektrischen Maschine zum Versorgen des Bordnetzes) oder als Wechselrichter (üblicherweise bei einem motorischen Betrieb der elektrischen Maschine) betrieben werden.

Die aktiven Schaltelemente 2, 3 sind über Stromschienen mit den Ständerwicklungssträngen 11 bis 15 einerseits und Gleichspannungsanschlüssen 5, 6 andererseits verbunden. Die Gleichspannungsanschlüsse 5, 6 können mit einer Stromspeichereinrichtung in einem Bordnetz, beispielsweise einer Batterie, verbunden sein. Der Gleichspannungsanschluss 5 ist dabei mit dem positiven Batteriepol, der Gleichspannungsanschluss 6 mit dem negativen Batteriepol bzw. Masse verbunden. Die aktiven Schaltelemente 2 sind damit im sogenannten oberen Gleichrichterzweig angeordnet, die aktiven Schaltelemente 3 im unteren Gleichrichterzweig. Bei den aktiven Schaltelementen 2 handelt es sich damit um sogenannte Highside-Schaltelemente, bei den aktiven Schaltelementen 3 um sogenannte Lowside-Schaltelemente. Man spricht auch von einem Highside-Pfad (vom Mittelpunkt der jeweiligen Stromrichterbrücken 21 bis 25 über die Schaltelemente 2 zu dem Gleichspannungsanschluss 5) bzw. einem Lowside-Pfad (vom Mittelpunkt der jeweiligen Stromrichterbrücken 21 bis 25 über die Schaltelemente 3 zu dem Gleichspannungsanschluss 6).

Eine Strommessung erfolgt herkömmlicherweise über Messwiderstände (Shunts) 4 in den Lowside-Pfaden des Stromrichters 20. Die Phasenströme können an dieser Stelle naturgemäß aber immer nur dann gemessen werden, wenn das zugehörige Lowside-Schaltelement 3 eingeschaltet ist. Dies wiederum ist aber nur dann der Fall, wenn der entsprechende Phasenstrom negativ ist.

Wie bereits zuvor erläutert, ergeben sich bei einer herkömmlichen Strommessung zahlreiche Nachteile. Diese können erfindungsgemäß überwunden werden, wobei nachfolgend die Erfindung unter Bezugnahme auf den PWM-Betrieb und den Blockbetrieb veranschaulicht wird.

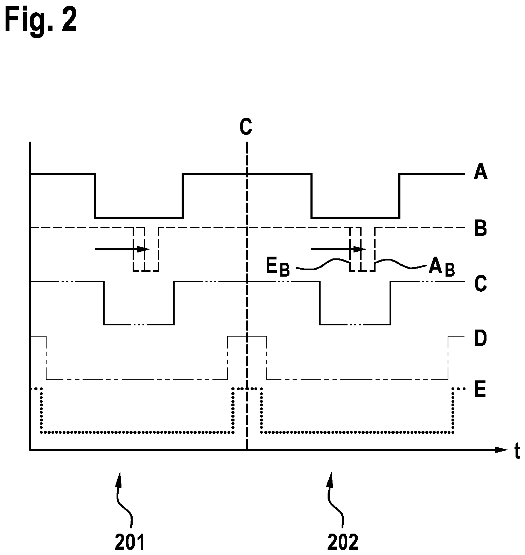

In Figur 2 ist ein PWM-Ansteuerschema gemäß einem sogenannten Centre-Aligned-Verfahren veranschaulicht. Das erfindungsgemäße Verfahren lässt sich jedoch auch bei anderen PWM-Verfahren, wie z.B. dem sogenannten Edge-Aligned-Verfahren, anwenden. Figur 2 zeigt dabei den Schaltzustand der Highside- Schaltelemente (vgl. Schaltelemente 2 der Figur 1) in den entsprechenden Phasen A - E einer fünfphasigen elektrischen Maschine über eine Zeit t. Die entsprechenden Lowside-Schaltelemente (z.B. die Schaltelemente 3) werden exakt invers hierzu angesteuert. Figur 2 zeigt dabei eine Ansteuerung innerhalb mehrerer Ansteuerperioden aufgetragen über die Zeit t. Die Blockbreiten der einzelnen Phasen sind ausschlaggebend für die Höhe des zu stellenden Phasenstroms.

Bei dem Centre-Aligned-Verfahren sind die Ansteuerblöcke symmetrisch zu einer Mittellinie C angeordnet. Das Ansteuermuster wiederholt sich mit einer konstanten Frequenz, wobei die Ansteuerbreiten drehwinkelabhängig verändert werden. Die Frequenz liegt üblicherweise im Bereich von z.B. 16 kHz und wird so gewählt, dass einerseits daraus entstehende Geräusche oberhalb des hörbaren Frequenzbereichs liegen, andererseits die beim Schalten der MOSFETs entstehenden Verluste möglichst gering sind. In Figur 2 sind die Schaltzustände der Highside-Schalter 2 gezeigt, wobei die jeweiligen Lowside-Schalter 3 grundsätzlich invers zu den ihnen zugeordneten Highside-Schaltern 2 geschaltet werden. Die Lowside-Schalter 3 sind somit in Bereichen niedriger Plateaus eingeschaltet.

Herkömmlicherweise erfolgt eine Strommessung innerhalb von Zeitintervallen 201, 202, in denen alle Lowside-Schaltelemente 3 eingeschaltet (und damit die Highside-Schaltelemente ausgeschaltet) sind, also während eines Ansteuerfensters der Lowside-Schaltelemente 3, wie in der Figur 2 mit schraffierten Flächen dargestellt ist. Allenfalls können die Phasenströme aller Phasen A - E noch ermittelt werden, wenn die Phasenströme von N - 1 Phasen messbar sind. Ist eines der Ansteuerfenster der Lowside-Schaltelemente 3 nun so kurz, dass der Phasenstrom nicht ermittelbar ist (vergleiche Phase B) so muss die Ansteuerdauer des jeweiligen Lowside-Schaltelementes 3 (vergleiche Phase B) entsprechend durch eine Verschiebung der Einschaltzeitpunkte $E_B$ bzw. Ausschaltzeitpunkte $A_B$ verlängert werden (dargestellt durch Pfeile in Figur 2). Eine derartige Veränderung des Pulsmusters hat jedoch eine erhöhte Momenten- und Spannungswelligkeit zur Folge und sollte daher vermieden werden.

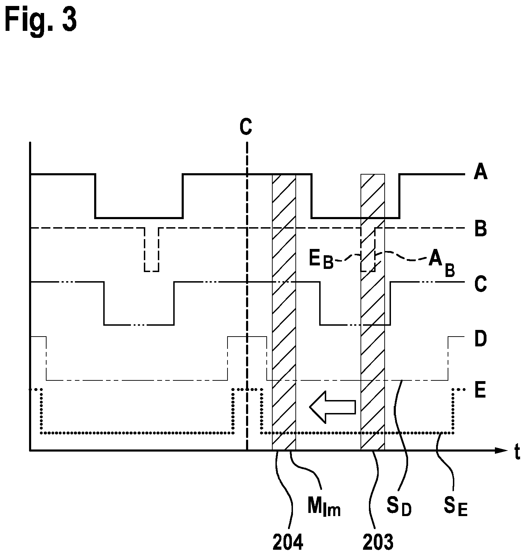

Werden, wie es erfindungsgemäß vorgesehen sein kann, aber nur drei oder nur zwei Phasenströme gemessen, kann die Messung zu jedem Zeitpunkt erfolgen, an dem die Lowside-Schaltelemente in den jeweils zu messenden Zweigen, d.h. in den Messphasen, geschlossen sind. Hinsichtlich zweier Phasen ist dies bei dem in Figur 3 gezeigten Ansteuerschema grundsätzlich in den Zeiträumen 203, 204 der Fall, in denen zumindest zwei der Lowside-Schalter 3 gleichzeitig eingeschaltet sind. In diesen Zeiträumen sind immer zumindest die Lowside-Schaltelemente in den Phasen D und E eingeschaltet, so dass deren Phasenströme gemessen werden können.

Eine Messung kann damit sehr viel häufiger erfolgen und bildet die realen Verhältnisse daher genauer ab. Insbesondere die feldorientierte Regelung kann hierdurch schneller mit besserer Regelungsgüte durchgeführt werden.

Es ist jedoch darauf zu achten, dass eine Messung nicht in Zeitbereichen stattfindet, in denen ein Highside-Schalter 2 und/oder ein Lowside-Schalter 3 eingeschaltet und oder ausgeschaltet wird bzw. werden, wie es beispielsweise im Zeitbereich 203 der Fall ist (vergleiche Phase B).

Während derartiger Schaltvorgänge kommt es in den Ständerwicklungen 11-15 zu Potentialsprüngen, welche eine Strommessung nicht nur der Phase, die gerade beschaltet wird, sondern aller Phasen (aufgrund von Kopplungseffekten innerhalb des Ständers) verfälscht. Zudem hätte die Ermittlung eines verfälschten Stromwertes der Messphasen einen systematischen Fehler bei der Berechnung der übrigen Phasenströme zur Folge, welcher zu vermeiden ist.

Es wird daher ein Messintervall $M_{l,m}$ derart gewählt und zeitlich positioniert (angedeutet durch den Pfeil in Figur 3), dass während des Messintervalls $M_{l,m}$ zumindest zwei der Lowside-Schalter 3 eingeschaltet sind (Schaltintervall $S_{D,E}$), das Messintervall $M_{l,m}$ ausreichend lange andauert, um die Phasenströme der zwei Messphasen, zum Beispiel der Phasen D und E, zu ermitteln und zudem innerhalb des Messintervalls $M_{l,m}$ keine Schaltvorgänge (z.B. Einschaltzeitpunkt $E_B$ oder Ausschaltzeitpunkt $A_B$) der Highside-Schalter 2 und/oder der Lowside-Schalter 3 stattfinden. Eine nachteilige Veränderung des Pulsmusters, kann somit vermieden werden.

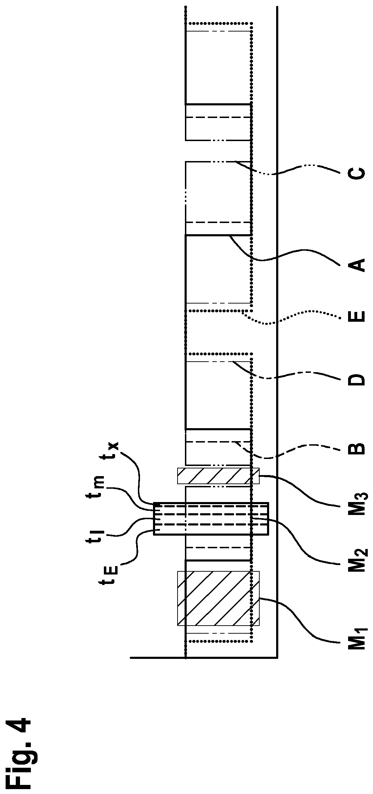

Das erfindungsgemäße Verfahren zur Ermittlung der zeitlichen Dauer und der zeitlichen Positionierung des Messintervalls $M_{l,m}$ wird anhand von Figur 4 beschrieben. In Figur 4 ist das zeitlich überlagerte Ansteuermuster der Schalter der Phasen A bis E dargestellt, wobei der Verlauf der Ansteuerung der jeweiligen Phasen A bis E mit unterschiedlich gestrichelten Linien dargestellt ist. Erfindungsgemäß ist vorgesehen, dass die Wahl und die zeitliche Positionierung des Messintervalls $M_{l,m}$ für jeden Schaltzyklus der Highside-Schalter 2 und/oder der Lowside-Schalter 3 erneut vorgenommen wird, was in Figur 4 exemplarisch für einen Schaltzyklus gezeigt ist.

Die zeitliche Dauer eines entsprechenden Messintervalls $M_{l,m}$ ist typischerweisegegeben durch zumindest eine Einschwingzeit $t_E$ zumindest einer der Ständerwicklungen 11-15, einer ersten Messzeit $t_l$ zur Messung des Phasenstroms $I_l$ der ersten Messphase D und einer weiteren Messzeit $t_m$ zur Messung des Phasenstroms $I_m$ der weiteren Messphase E. Die Einschwingzeit $t_E$ beträgt typischerweise zwischen 10 μs und 20 μs (Mikrosekunden), insbesondere etwa 13 μs, und die erste Messzeit $t_l$ und die weitere Messzeit $t_m$ betragen jeweils zwischen 2 μs und 10 μs, insbesondere etwa 3 μs. Hierbei handelt es sich lediglich um typische Werte für eine entsprechende elektrische Maschine 10. Es versteht sich grundsätzlich, dass die zuvor genannten Zeiten entsprechend der maschinenseitigen Parameter angepasst werden können.

Um ein Messintervall $M_{l,m}$ bestmöglich zwischen den einzelnen Schaltvorgängen zu positionieren, werden die Einschaltzeitpunkte $E_{k,l,m}$ und die Ausschaltzeitpunkte $A_{k,l,m}$ der Highside-Schalter 2 und/oder der Lowside-Schalter 3 erfasst und entsprechend ihrer zeitlichen Anordnung sortiert. Im Anschluss werden die Zeitdifferenzen unmittelbar benachbarter Schaltvorgänge anhand der ermittelten Einschaltzeitpunkte $E_{k,l,m}$ und Ausschaltzeitpunkte $A_{k,l,m}$ der Highside-Schalter 2 und/oder der Lowside-Schalter 3 berechnet (vgl. Figur 3). Ist entsprechend die berechnete Zeitdifferenz größer als die für eine einzelne Messung eines Phasenstroms erforderliche Zeitdauer, gegebenenfalls unter weiterer Berücksichtigung der eingangs genannten Einschwingzeit $t_E$, so wird geprüft, wie viele weitere Phasenströme I innerhalb des zur Verfügung stehenden Zeitfensters ermittelbar sind.

Grundsätzlich müssen innerhalb des Messintervalls $M_{l,m}$ zumindest die Phasenströme zweier Messphasen ermittelbar sein. Es ist jedoch vorteilhaft, sofern möglich, möglichst viele Phasenströme innerhalb des jeweiligen Messintervalls $M_{l,m}$ zu ermitteln, da hierdurch die Berechnung der weiteren Phasenströme mit entsprechend höherer Genauigkeit erfolgen kann. Auf diese Weise werden sämtliche potentiell den Anforderungen eines Messintervalls $M_{l,m}$ entsprechenden Messfenster, gemäß der zuvor genannten Kriterien, geprüft und es wird bevorzugt das Messintervall $M_{l,m}$ ausgewählt, in dem die größtmögliche Anzahl an Phasenströmen gemessen werden kann. Dies ist in Figur 4 anhand der Messfenster $M_1$ bis $M_3$ exemplarisch dargestellt.

Das Messfenster $M_1$ ist ausreichend lang für eine Phasenstrommessung, jedoch ist innerhalb dieses Zeitintervalls nur eine Phase (E) nach Lowside geschaltet und die übrigen Phasenströme sind innerhalb dieses Zeitintervalls nicht messbar. Da zumindest zwei Phasenströme messbar sein müssen, scheidet dieses Zeitfenster daher aus.

Das Messfenster $M_3$ liegt in einem Zeitintervall, in dem alle Lowside-Schalter 3 durchgeschaltet sind, weswegen grundsätzlich auch alle Phasenströme der Phasen A bis E messbar wären. Jedoch ist das Messfenster $M_3$ derart kurz, dass eine Phasenstrommessung zumindest zweier Messphasen nicht bewirkt werden kann. Aus diesem Grund scheidet dieses Zeitfenster zur Ermittlung der Phasenströme aus.

Das Messfenster $M_2$ ist ausreichend lang für die Phasenstrommessung zumindest zweier Messphasen $t_l$ und $t_m$. Das Messfenster $M_2$ bietet überdies noch eine ausreichende Zeitreserve, um auch die Einschwingzeit $t_E$ und zumindest die Messung eines Phasenstroms einer weiteren Messphase $t_x$ unterzubringen. Somit handelt es sich bei dem Messfenster $M_2$ um das bevorzugte Messintervall $M_{l,m}$, das im Rahmen des erfindungsgemäßen Verfahrens vorzugsweise zu ermitteln ist.

Die rechnerische Ermittlung der übrigen Phasenströme unter Heranziehung der Phasenströme zweier Messphasen, exemplarisch dargestellt unter Verwendung von nur zwei Messwiderständen in fünfphasigen elektrischen Maschinen, wird nachfolgend erläutert. Die hier erläuterten Prinzipien können vom Fachmann auf vier- oder mehrphasige Maschinen übertragen werden, wie ebenfalls angegeben.

Geht man von einem sinusförmigen Stromverlauf $I(\varphi) = I_0 \times \sin\varphi$ aus, lassen sich aus zwei Phasenströmen alle fehlenden Phasenströme berechnen.

Zur Berechnung eines Phasenstromwerts $I_k(\varphi_0)$ einer Phase $k$ aus bekannten (gemessenen) Stromwerten $I_l(\varphi_0)$, $I_m(\varphi_0)$ der Phasen $l$ bzw. $m$ gilt:

$$I_k\left(\varphi_0\right) = \frac{I_l\left(\varphi_0\right) - I_m\left(\varphi_0\right) \cdot \frac{\sin\delta_{kl}}{\sin\delta_{km}}}{\cos\delta_{kl} - \frac{\sin\delta_{kl}}{\tan\delta_{km}}}$$

Die Berechnung läuft zweckmäßigerweise diskret ab, wird also mit einer bestimmten Zykluszeit aufgerufen. Die aktuellen Phasenströme werden dann einmal pro Zyklus berechnet.

Dabei bezeichnet $\delta_{kl}$ den räumlichen Winkelversatz zwischen der Phase k und der Phase $l$. Der räumliche Winkelversatz zwischen zwei benachbarten Phasen beträgt bei einem üblichen symmetrischen Aufbau des Ständers der elektrischen Maschine 360°/N.

Werden beispielsweise bei N=6 Phasen die Phasenströme der Phasen 3 und 5 ($I_3$ und $I_5$) gemessen, gilt: $l$ = 3, $m$ = 5 und $N$ = 6. Damit gilt: $\delta_{13}$ = 180° und $\delta_{15}$ = 300°.

Soll beispielsweise in einem fünfphasigen System mit den Phasen A - E der Phasenstrom der Phase A ($I_A$) aus den Phasenströmen der Phasen B und C ($I_B$ und $I_C$) berechnet werden, beträgt der räumliche Winkelversatz $\delta_{AB}$ = 360° / 5 = 72° und der räumliche Winkelversatz $\delta_{AC}$ = 2 × 360° / 5 = 144°.

Auch die Phasenströme der übrigen Phasen ($I_D$ und $I_E$) können aus $I_B$ und $I_C$ berechnet werden, indem die jeweiligen Differenzwinkel eingesetzt werden. Ausgehend von dieser Nomenklatur ergeben sich auch die Einschaltzeitpunkte $E_{k,l,m}$, die Ausschaltzeitpunkte $A_{k,l,m}$ und die hierdurch zeitlich begrenzten Schaltintervalle $S_{k,l,m}$, der den jeweiligen Phasen A bis D zugeordneten Highside-Schalter 2 und/oder der Lowside-Schalter 3, entsprechend (vgl. Figur 3). Die Einschaltzeitpunkte und Ausschaltzeitpunkte der Highside-Schalter 2 sind, wie eingangs bereits erwähnt, invers zu denen der Lowside-Schalter 3.

Die Erfindung eignet sich auch in besonderer Weise zur Strommessung im sogenannten Blockbetrieb. Ab einer bestimmten Drehzahl, der sogenannten Eckdrehzahl, erreicht die elektrische Maschine die sogenannte Spannungsgrenze. Bei dieser ist die erzeugte Polradspannung größer als die an den Phasen anliegende Spannung. Damit die Maschine oberhalb dieser Drehzahl ein motorisches Moment erzeugen kann, wird sie im sogenannten Feldschwächbetrieb betrieben. Da diese Betriebsart jedoch einen geringeren Wirkungsgrad aufweist, sollte die Eckdrehzahl möglichst hoch liegen, was beispielsweise durch eine höhere Phasenspannung erreicht werden kann. Daher werden entsprechende Maschinen im Feldschwächbereich im Blockbetrieb statt dem zuvor erläuterten PWM-Betrieb angesteuert, da in diesem eine größere effektive Spannung an der Ständerwicklung erzeugt werden kann, als bei einer PWM-Ansteuerung.

Im Gegensatz zur PWM-Ansteuerung wird beim Blockbetrieb keine feste Ansteuerfrequenz verwendet, sondern die Schaltelemente werden synchron zur elektrischen Winkelgeschwindigkeit der elektrischen Maschine blockförmig ein- und ausgeschaltet. Je nach Phasenzahl lassen sich verschiedene Blockbreiten realisieren. Die Ansteuerart, die die größte effektive Phasenspannung erzeugt, ist die sogenannte 180°-Blockkommutierung, bei welcher pro Phase innerhalb einer elektrischen Umdrehung die Highside- und Lowside-Schaltelemente (vgl. Figur 1) jeweils für einen elektrischen Winkel von 180° eingeschaltet sind.

In der nachfolgenden Tabelle 1 ist das Ansteuermuster bei einer 180°-Blockkommutierung für eine fünfphasige elektrische Maschine dargestellt. Innerhalb einer elektrischen Umdrehung ergeben sich hier 10 verschiedene Ansteuermuster, die stets nach einem elektrischen Winkel von 36° umgeschaltet werden. Mit 1 ist jeweils ein eingeschaltetes Highside-Schaltelement, mit 0 ein eingeschaltetes Lowside-Schaltelement bezeichnet.

Tabelle 1

| $\varphi$ | A | B | C | D | E |
|------|---|---|---|---|---|
| 0° | 0 | 0 | 0 | 1 | 1 |
| 36° | 0 | 0 | 1 | 1 | 1 |
| 72° | 0 | 0 | 1 | 1 | 0 |
| 108° | 0 | 1 | 1 | 1 | 0 |
| 144° | 0 | 1 | 1 | 0 | 0 |
| 180° | 1 | 1 | 1 | 0 | 0 |
| 216° | 1 | 1 | 0 | 0 | 0 |

(fortgesetzt)

| $\varphi$ | A | B | C | D | E |
|---|---|---|---|---|---|
| 252° | 1 | 1 | 0 | 0 | 1 |
| 288° | 1 | 0 | 0 | 0 | 1 |
| 324° | 1 | 0 | 0 | 1 | 1 |

Gegenüber der PWM-Ansteuerung fällt auf, dass zu keinem Zeitpunkt alle (oder zumindest alle bis auf ein) Lowside-Schaltelemente gleichzeitig eingeschaltet sind. Für eine rein messtechnische Ermittlung der Phasenströme müsste daher eine derartige Ansteuerung, auch als Schaltvektor bezeichnet, rein zu Messzwecken herbeigeführt werden, indem zu definierten Zeitpunkten kurzzeitig alle (oder alle bis auf ein) Lowside-Schaltelemente eingeschaltet werden. Nachteilig hieran ist jedoch, dass hierdurch das erzeugte Moment reduziert wird.

Aus der obigen Tabelle ist jedoch auch erkennbar, dass zu jedem Zeitpunkt mindestens zwei Lowside-Schaltelemente eingeschaltet sind. Die vorliegende Erfindung sieht dabei vorteilhafterweise vor, immer diejenigen Phasenströme zu messen, die gerade verfügbar sind z.B.:

| | |
|---|---|
| 0° - 71°: | Phasen A und B |
| 72° - 143°: | Phasen A und E |
| 144° - 215°: | Phasen D und E |
| 216° - 287°: | Phasen C und D |
| 288° - 359°: | Phasen B und C |

Soll die Anzahl der Messwiderstände reduziert werden, ergeben sich Winkelbereiche, in denen kein Strom messbar ist, da nur Lowside-Schaltelemente in denjenigen Phasen geschlossen sind, denen keine Messwiderstände zugeordnet sind. Da der Blockbetrieb erst bei hohen Drehzahlen eingesetzt wird, sind diese Zeitbereiche gegebenenfalls hinreichend klein, so dass mit den zuletzt ermittelten Phasenströmen gerechnet werden kann.

Durch eine messtechnisch vorteilhafte Platzierung der Messwiderstände, also der Strommessstellen, lässt sich Anzahl der Winkelsegmente ohne Strommessung minimieren. In der nachfolgenden Tabelle 2 ist der Fall einer elektrischen Maschine mit fünf Phasen und einem Stromrichter dargestellt, die beispielsweise der Anordnung entspricht, die in Figur 1 dargestellt ist. Hierbei sind jedoch nur drei Messwiderstände in den Phasen A, B und C vorgesehen.

Im linken Tabellenteil sind die Schaltzustände der Schaltelemente, wie bezüglich Tabelle 1 erläutert, dargestellt, wobei auf eine Angabe des räumlichen Winkels der zugehörigen Phasen verzichtet wurde. Im rechten Tabellenteil ist dargestellt, wie die einzelnen Phasenströme ermittelt werden. Buchstabe M bedeutet dabei, dass die entsprechenden Phasenströme gemessen werden, die Buchstaben A bis E geben an, aus welchen Phasenströmen die in der Kopfzeile angegebenen Phasenströme rechnerisch bestimmt werden (beispielsweise erste Zeile: $I_A$, $I_B$ und $I_C$ werden gemessen, $I_D$ und $I_E$ werden aus $I_A$ und $I_C$ rechnerisch bestimmt).

Tabelle 2

| A | B | C | D | E | $I_A$ | $I_B$ | $I_C$ | $I_D$ | $I_E$ |
|---|---|---|---|---|---|---|---|---|---|
| 0 | 0 | 0 | 1 | 1 | M | M | M | A,C | A,C |
| 0 | 0 | 1 | 1 | 1 | M | M | A,B | A,B | A,B |
| 0 | 0 | 1 | 1 | 0 | M | M | A,B | A,B | A,B |
| 0 | 1 | 1 | 1 | 0 | M | - | - | - | - |
| 0 | 1 | 1 | 0 | 0 | M | - | - | - | - |
| 1 | 1 | 1 | 0 | 0 | - | - | - | - | - |
| 1 | 1 | 0 | 0 | 0 | - | - | M | - | - |
| 1 | 1 | 0 | 0 | 1 | - | - | M | - | - |
| 1 | 0 | 0 | 0 | 1 | B,C | M | M | B,C | M |
| 1 | 0 | 0 | 1 | 1 | B,C | M | M | B,C | M |

Man erkennt, dass in diesem Fall nur in fünf der zehn Winkelsegmente (entsprechend den Tabellenzeilen 1, 2, 3, 9 und 10) eine Messung der Phasenströme zweier Phasen, und damit eine Ermittlung der Phasenströme aller Phasen, möglich ist, da nur in diesen zwei der Lowside-Schaltelemente in den Phasen A, B und C geschlossen sind. In allen anderen Winkelsegmenten kann gar kein oder nur ein Phasenstrom gemessen werden, so dass sich die übrigen Phasenströme nicht ermitteln lassen.

In der der nachfolgenden Tabelle 3 zugrundeliegenden Anordnung, die im Übrigen ebenfalls jener der Figur 1 und in der Darstellung der Tabelle 2 entspricht, sind hingegen zwei Messwiderstände in einer gemeinsamen Zuleitung der Phasen A und D sowie C und E sowie ein weiterer Messwiderstand in Phase B vorhanden. Man erkennt, dass in diesem Fall in acht von zehn Winkelsegmenten die Phasenströme aller Phasen ermittelt werden können.

Tabelle 3

| A | B | C | D | E | $I_A$ | $I_B$ | $I_C$ | $I_D$ | $I_E$ |
|---|---|---|---|---|---|---|---|---|---|
| 0 | 0 | 0 | 1 | 1 | M | M | M | AC | AC |
| 0 | 0 | 1 | 1 | 1 | M | M | AB | AB | AB |
| 0 | 0 | 1 | 1 | 0 | M | M | AE | AE | M |
| 0 | 1 | 1 | 1 | 0 | M | AE | AE | AE | M |
| 0 | 1 | 1 | 0 | 0 | - | - | - | - | M |
| 1 | 1 | 1 | 0 | 0 | DE | DE | DE | M | M |
| 1 | 1 | 0 | 0 | 0 | - | - | - | M | - |
| 1 | 1 | 0 | 0 | 1 | CD | CD | M | M | CD |
| 1 | 0 | 0 | 0 | 1 | CD | M | M | M | CD |
| 1 | 0 | 0 | 1 | 1 | BC | M | M | BC | BC |

Die Phasenströme aller Phasen lassen sich nur dann nicht berechnen, wenn die Lowside-Schaltelemente in den Phasen A und D bzw. C und E gleichzeitig eingeschaltet sind, da in diesem Fall deren individuelle Phasenströme nicht gemessen werden können.

In der Anordnung, die der nachfolgenden Tabelle 4 zugrundeliegt, sind zwei Messwiderstände in den Phasen A und B vorgesehen. Die Anordnung entspricht im Übrigen jener der Figur 1, die Darstellung den Tabellen 2 und 3. Man erkennt, dass in diesem Fall nur in den ersten drei der zehn Winkelsegmente eine Strommessung möglich ist, da nur hier die Lowside-Schaltelemente der Phasen A und B geschlossen sind. In allen anderen Winkelsegmenten kann gar kein oder nur ein Phasenstrom gemessen werden, so dass sich die Phasenströme der anderen Phasen nicht ermitteln lassen.

Tabelle 4

| A | B | C | D | E | $I_A$ | $I_B$ | $I_C$ | $I_D$ | $I_E$ |
|---|---|---|---|---|---|---|---|---|---|
| 0 | 0 | 0 | 1 | 1 | M | M | A,B | A,B | A,B |
| 0 | 0 | 1 | 1 | 1 | M | M | A,B | A,B | A,B |
| 0 | 0 | 1 | 1 | 0 | M | M | A,B | A,B | A,B |
| 0 | 1 | 1 | 1 | 0 | M | - | - | - | - |
| 0 | 1 | 1 | 0 | 0 | M | - | - | - | - |
| 1 | 1 | 1 | 0 | 0 | - | - | - | - | - |
| 1 | 1 | 0 | 0 | 0 | - | - | - | - | - |
| 1 | 1 | 0 | 0 | 1 | - | - | - | - | - |
| 1 | 0 | 0 | 0 | 1 | - | M | - | - | - |
| 1 | 0 | 0 | 1 | 1 | - | M | - | - | - |

In der Anordnung, die der nachfolgenden Tabelle 5 zugrundeliegt, sind hingegen zwei Stromsensoren in einer gemeinsamen Zuleitung der Phasen A und D sowie C und E vorhanden. In diesem Fall können in sechs von zehn Winkelsegmenten alle Phasenströme ermittelt werden. Dies ist nicht möglich, wenn entweder nur zwei Lowside-Schaltelemente geschlossen sind und eines davon in Phase B liegt oder die Lowside-Schaltelemente in den Phasen A und D bzw. C und E gleichzeitig geschlossen sind, da sich dann die individuellen Phasenströme dieser Phasen nicht ermitteln lassen.

Das Verfahren lässt sich, falls erforderlich, noch weiter optimieren, indem jeweils in den nicht messbaren Winkelsegmenten für kurze Zeit ein weiteres Lowside-Schaltelement eingeschaltet wird, was im Sprachgebrauch dieser Anmeldung als "Einstellen eines Messmodus des Stromrichters" bezeichnet wird. Wie oben beschrieben, wird dadurch zwar ein geringfügig geringeres Moment erzeugt, der Verlust ist aber hier deutlich geringer, da nur in einer Phase ein Schalteingriff erforderlich ist.

Tabelle 5

| A | B | C | D | E | $I_A$ | $I_B$ | $I_C$ | $I_D$ | $I_E$ |
|---|---|---|---|---|---|---|---|---|---|
| 0 | 0 | 0 | 1 | 1 | M | A,C | M | A,C | A,C |
| 0 | 0 | 1 | 1 | 1 | M | - | - | - | - |
| 0 | 0 | 1 | 1 | 0 | M | A,E | A,E | A,E | M |
| 0 | 1 | 1 | 1 | 0 | M | A,E | A,E | A,E | M |
| 0 | 1 | 1 | 0 | 0 | - | - | - | - | M |
| 1 | 1 | 1 | 0 | 0 | D,E | D,E | D,E | M | M |
| 1 | 1 | 0 | 0 | 0 | - | - | - | M | - |
| 1 | 1 | 0 | 0 | 1 | C,D | C,D | M | M | C,D |
| 1 | 0 | 0 | 0 | 1 | C,D | C,D | M | M | C,D |
| 1 | 0 | 0 | 1 | 1 | - | - | M | - | - |

## Patentansprüche

1.  Verfahren zur Ermittlung der Phasenströme ($I_{k,l,m}$) einer elektrischen Maschine mit einem Stromrichter (20) und einem Ständer (10) umfassend Ständerwicklungen (11-15) mit einer Phasenzahl von zumindest drei,

    bei dem die Phasenströme ($I_{l,m}$) einer Anzahl von Messphasen, die zumindest zwei beträgt, gemessen werden, wobei die Phasenströme der Messphasen jeweils in einem Messintervall ($M_{l,m}$) gemessen werden, wenn die den Messphasen zugeordneten aktiven Schaltelemente (3) in einem Lowside-Pfad des Stromrichters (20) in einem Schaltintervall ($S_{l,m}$), das von einem Einschaltzeitpunkt ($E_{l,m}$) und einem Ausschaltzeitpunkt ($A_{l,m}$) begrenzt ist, angesteuert werden,
    wobei die Phasenströme ($I_k$) der übrigen Phasen derart rechnerisch aus den gemessenen Phasenströmen ($I_{l,m}$) bestimmt werden, dass zur rechnerischen Bestimmung zumindest die gemessenen Phasenströme ($I_{l,m}$), ein räumlicher Winkel der Messphasen und ein räumlicher Winkel der übrigen Phasen verwendet werden,
    wobei das Messintervall ($M_{l,m}$) derart gewählt wird, dass die Einschaltzeitpunkte und Ausschaltzeitpunkte ($A_{k,l,m}$) der den Phasen des Ständers zugeordneten aktiven Schaltelemente des Stromrichters (20) außerhalb des Messintervalls liegen,
    **dadurch gekennzeichnet, dass** die Einschaltzeitpunkte ($E_{k,l,m}$) und die Ausschaltzeitpunkte ($A_{k,l,m}$) erfasst und in zeitlicher Reihenfolge sortiert werden, wobei die Zeitdifferenz zwischen einem Einschaltzeitpunkt ($E_{k,l,m}$) oder einem Ausschaltzeitpunkt ($A_{k,l,m}$) und dem direkt benachbarten Einschaltzeitpunkt ($E_{k,l,m}$) oder Ausschaltzeitpunkt ($A_{k,l,m}$) erfasst und mit dem Messintervall ($M_{l,m}$), insbesondere mit der zeitlichen Dauer des Messintervalls ($M_{l,m}$), verglichen wird,
    wobei das Messintervall ($M_{l,m}$) derart gewählt und zeitlich zwischen den jeweiligen Einschaltzeitpunkten ($E_{k,l,m}$) oder Ausschaltzeitpunkten ($A_{k,l,m}$) angeordnet wird, dass innerhalb des Messintervalls ($M_{l,m}$) eine größtmögliche Anzahl von Phasenströmen gemessen werden können.

2.  Verfahren nach Anspruch 1, **dadurch gekennzeichnet, dass** das Messintervall ($M_{l,m}$) zumindest eine Einschwingzeit ($t_E$) zumindest einer der Ständerwicklungen (11-15), eine erste Messzeit ($t_l$) zur Messung des Phasenstroms ($I_l$) der ersten Messphase und eine weitere Messzeit ($t_m$) zur Messung des Phasenstroms ($I_m$) der weiteren Mess-

phase aufweist, wobei die Einschwingzeit ($t_E$) vorzugsweise zwischen 10 μs und 20 μs, besonders bevorzugt etwa 13 μs, und die erste Messzeit ($t_l$) und die weitere Messzeit ($t_m$) jeweils zwischen 2μs und 10μs, besonders bevorzugt etwa 3 μs, liegt.

3. Verfahren nach Anspruch 1 oder 2, **dadurch gekennzeichnet, dass** das Messintervall ($M_{l,m}$) derart gewählt wird, dass die Einschaltzeitpunkte und Ausschaltzeitpunkte ($A_{k,l,m}$) der aktiven Schaltelemente) in einem Highside-Pfad des Stromrichters (20) und/oder der aktiven Schaltelemente (3) in einem Lowside-Pfad des Stromrichters (20) außerhalb des Messintervalls liegen.

4. Verfahren nach einem der vorstehenden Ansprüche, **dadurch gekennzeichnet, dass** das Messintervall ($M_{l,m}$) derart gewählt und zeitlich zwischen den jeweiligen Einschaltzeitpunkten ($E_{k,l,m}$) oder Ausschaltzeitpunkten ($A_{k,l,m}$) angeordnet wird, dass die Zeitdifferenz zumindest dem Messintervall ($M_{l,m}$) entspricht.

5. Verfahren nach einem der vorstehenden Ansprüche, **dadurch gekennzeichnet, dass** die Einschaltzeitpunkte ($E_{k,l,m}$) und die Ausschaltzeitpunkte ($A_{k,l,m}$) zeitlich wiederkehrend, insbesondere periodisch, angeordnet sind und das Messintervall ($M_{l,m}$) für jeden Zyklus erneut ermittelt wird.

6. Verfahren nach einem der vorstehenden Ansprüche, **dadurch gekennzeichnet, dass** bei einem Pulsweitenmodulationsbetrieb und/oder einem Blockbetrieb des Stromrichters (20) durchgeführt wird.

7. Verfahren nach einem der vorstehenden Ansprüche, **dadurch gekennzeichnet, dass** die Phasenströme von wenigstens zwei Messphasen in Form eines Summenstroms gemessen werden.

8. Verfahren nach einem der vorstehenden Ansprüche, **dadurch gekennzeichnet, dass** der räumliche Winkel der Messphasen und der übrigen Phasen auf Grundlage einer geometrischen Anordnung der Messphasen und der übrigen Phasen in der elektrischen Maschine bestimmt wird.

9. Recheneinheit, die dazu eingerichtet ist, ein Verfahren nach einem der vorstehenden Ansprüche durchzuführen.

10. Kraftfahrzeugbordnetz mit einer Recheneinheit nach Anspruch 9.

11. Computerprogramm mit Programmcodemitteln, die eine Recheneinheit veranlassen, ein Verfahren nach einem der Ansprüche 1 bis 8 durchzuführen, wenn sie auf der Recheneinheit, insbesondere nach Anspruch 9, ausgeführt werden.

12. Maschinenlesbares Speichermedium mit einem darauf gespeicherten Computerprogramm, welches Programmcodemittel aufweist, die eine Recheneinheit veranlassen, ein Verfahren nach einem der Ansprüche 1 bis 8 durchzuführen, wenn sie auf der Recheneinheit ausgeführt werden.

**Claims**

1. A method for determining the phase currents ($I_{k,l,m}$) of an electric machine with a converter (20) and a stator (10) comprising stator windings (11-15) with a phase number of at least three,

    in which the phase currents ($I_{l,m}$) of a number of measurement phases, which is at least two, are measured, wherein the phase currents of the measurement phases are each measured in a measurement interval ($M_{l,m}$) when the active switching elements (3) in a lowside path of the converter (20) associated with the measurement phases are driven in a switching interval ($S_{l,m}$), which is limited by a switch-on time ($E_{l,m}$) and a switch-off time ($A_{l,m}$),
    wherein the phase currents ($I_k$) of the remaining phases are determined computationally from the measured phase currents ($I_{l,m}$) in such a way that at least the measured phase currents ($I_{l,m}$), a spatial angle of the measurement phases and a spatial angle of the remaining phases are used for the computational determination, the measurement interval ($M_{l,m}$) being selected in such a way that the switch-on times and switch-off times ($A_{k,l,m}$) of the active switching elements of the converter (20) assigned to the phases of the stator lie outside the measurement interval,
    **characterized in that** the switch-on times ($E_{k,l,m}$) and the switch-off times ($A_{k,l,m}$) are detected and sorted in time sequence, the time difference between a switch-on time ($E_{k,l,m}$) or a switch-off time ($A_{k,l,m}$) and the directly adjacent switch-on time ($E_{k,l,m}$) or switch-off time ($A_{k,l,m}$) is detected and compared with the measurement interval ($M_{l,m}$), in particular with the time duration of the measurement interval ($M_{l,m}$), the measurement interval ($M_{l,m}$) being selected and arranged in time between the respective switch-on times ($E_{k,l,m}$) or switch-off times ($A_{k,l,m}$) in such a way that the greatest possible number of phase currents can be measured within the measurement interval ($M_{l,m}$).

2. The method according to claim 1, **characterized in that** the measurement interval ($M_{l,m}$) has at least one transient time ($t_E$) of at least one of the stator windings (11-15), a first measurement time (ti) for measuring the phase current (II) of the first measurement phase and a further measurement time (tm) for measuring the phase current ($I_m$) of the further measurement phase, wherein the transient time ($t_E$) is preferably between 10 μs and 20 μs, particularly preferably about 13 μs, and the first measurement time ($t_l$) and the further measurement time ($t_m$) are each between 2μs and 10μs, particularly preferably about 3 μs.

3. The method according to claim 1 or 2, **characterized in that** the measurement interval ($M_{l,m}$) is selected in such a way that the switch-on times and switch-off times ($A_{k,l,m}$) of the active switching elements in a high-side path of the converter (20) and/or of the active switching elements (3) in a low-side path of the converter (20) lie outside the measurement interval.

4. The method according to any one of the preceding claims, **characterized in that** the measurement interval ($M_{l,m}$) is selected and arranged in time between the respective switch-on times ($E_{k,l,m}$) or switch-off times ($A_{k,l,m}$) in such a way that the time difference corresponds at least to the measurement interval ($M_{l,m}$).

5. The method according to any one of the preceding claims, **characterized in that** the switch-on times ($E_{k,l,m}$) and the switch-off times ($A_{k,l,m}$) are arranged in a time-recurring manner, in particular periodically, and the measurement interval ($M_{l,m}$) is determined again for each cycle.

6. The method according to any one of the preceding claims, **characterized in that** is carried out during a pulse width modulation operation and/or a block operation of the converter (20).

7. The method according to any one of the preceding claims, **characterized in that** the phase currents of at least two measurement phases are measured in the form of a sum current.

8. The method according to any one of the preceding claims, **characterized in that** the spatial angle of the measurement phases and the remaining phases is determined on the basis of a geometrical arrangement of the measurement phases and the remaining phases in the electrical machine.

9. A computing unit adapted to perform the method according to any one of the preceding claims.

10. A motor vehicle electrical system comprising a computing unit according to claim 9.

11. A computer program comprising program code means which cause a computing unit to perform a method according to any one of claims 1 to 8 when executed on the computing unit, in particular according to claim 9.

12. A machine-readable storage medium having a computer program stored thereon, the computer program having program code means for causing a computing unit to perform a method according to any one of claims 1 to 8 when executed on the computing unit.

**Revendications**

1. Procédé destiné à déterminer les courants de phase ($I_{k,l,m}$) d'une machine électrique comportant un convertisseur (20) et un stator (10) incluant des enroulements de stator (11 à 15) ayant un nombre de phases au moins égal à trois,

dans lequel les courants de phase ($I_{l,m}$) d'une pluralité de phases de mesure au moins égale à deux, sont mesurés,
dans lequel les courants de phase des phases de mesure sont respectivement mesurés sur un intervalle de mesure ($M_{l,m}$) lorsque les éléments de commutation actifs (3) associés aux phases de mesure sont commandés dans un trajet côté basse tension du convertisseur (20) sur un intervalle de commutation ($S_{l,m}$) qui est délimité par un instant de mise sous tension ($E_{l,m}$) et un instant de mise hors tension ($A_{l,m}$), dans lequel les courants de phase ($I_k$) des phases restantes sont déterminés par calcul à partir des courants de phase ($I_{l,m}$) mesurés de telle sorte que pour la détermination par calcul, au moins les courants de phase ($I_{l,m}$) mesurés, un angle spatial des phases de mesure et un angle spatial des phases restantes sont utilisés, dans lequel l'intervalle de mesure ($M_{l,m}$) est sélectionné de telle sorte que les instants de mise sous tension et les instants de mise hors tension ($A_{k,l,m}$) des éléments de commutation actifs du convertisseur (20) associés aux phases du stator se situent en dehors de l'intervalle de mesure, **caractérisé en ce que** les instants de mise sous tension ($E_{k,l,m}$) et les instants de mise hors tension ($A_{k,l,m}$) sont détectés et sont triés dans un ordre chronologique, dans lequel la différence de temps entre un instant de mise sous tension ($E_{k,l,m}$) ou un instant de mise hors tension ($A_{k,l,m}$) et l'instant de mise sous tension ($E_{k,l,m}$) ou l'instant de mise hors tension ($A_{k,l,m}$) directement adjacent est détectée et comparée à l'intervalle de mesure ($M_{l,m}$), en particulier à la durée de l'intervalle de mesure ($M_{l,m}$), dans lequel l'intervalle de mesure ($M_{l,m}$) est sélectionné et positionné temporellement entre l'instant de mise sous tension ($E_{k,l,m}$) ou l'instant de mise hors tension ($A_{k,l,m}$) respectif de manière à pouvoir mesurer le plus grand nombre possible de courants de phase à l'intérieur de l'intervalle de mesure ($M_{l,m}$).

**2.** Procédé selon la revendication 1, **caractérisé en ce que** l'intervalle de mesure ($M_{l,m}$) comporte au moins un temps de stabilisation ($t_E$) d'au moins un des enroulements de stator (11 à 15), un premier temps de mesure ($t_l$) pour mesurer le courant de phase ($I_l$) de la première phase de mesure et un temps de mesure supplémentaire ™ pour mesurer le courant de phase ($I_m$) de la phase de mesure supplémentaire, dans lequel le temps de stabilisation ($t_E$) est de préférence compris entre 10 µs et 20 µs, de manière particulièrement préférée égal à environ 13 µs, et le premier temps de mesure ($t_l$) et le temps de mesure supplémentaire ™ sont respectivement compris entre 2 µs et 10 µs, de manière particulièrement égaux à 3 µs.

**3.** Procédé selon la revendication 1 ou 2, **caractérisé en ce que** l'intervalle de mesure ($M_{l,m}$) est sélectionné de telle sorte que les instants de mise sous tension et les instants de mise hors tension ($A_{k,l,m}$) des éléments de commutation actifs se situent dans un trajet côté haute tension du convertisseur (20) et/ou les instants de mise sous tension et les instants de mise hors tension ($A_{k,l,m}$) des éléments de commutation actifs (3) se situent dans un trajet côté basse tension du convertisseur (20) à l'extérieur de l'intervalle de mesure.

**4.** Procédé selon l'une des revendications précédentes, **caractérisé en ce que** l'intervalle de mesure ($M_{l,m}$) est sélectionné et positionné temporellement entre les instants de mise sous tension ($E_{k,l,m}$) ou les instants de mise hors tension ($A_{k,l,m}$) respectifs de telle sorte que la différence de temps correspond au moins à l'intervalle de mesure ($M_{l,m}$).

**5.** Procédé selon l'une des revendications précédentes, **caractérisé en ce que** les instants de mise sous tension ($E_{k,l,m}$) et les instants de mise hors tension ($A_{k,l,m}$) sont positionnés de manière récurrente dans le temps, en particulier de manière périodique, et l'intervalle de mesure ($M_{l,m}$) est de nouveau déterminé pour chaque cycle.

**6.** Procédé selon l'une des revendications précédentes, **caractérisé en ce qu'**il est mis en œuvre dans un mode de modulation de largeur d'impulsion et/ou un mode de blocage du convertisseur (20).

**7.** Procédé selon l'une des revendications précédentes, **caractérisé en ce que** les courants de phase d'au moins deux phases de mesure sont mesurés sous la forme d'un courant cumulé.

**8.** Procédé selon l'une des revendications précédentes, **caractérisé en ce que** l'angle spatial des phases de mesure et des phases restantes est déterminé sur la base d'un agencement géométrique des phases de mesure et des phases restantes dans la machine électrique.

**9.** Unité de calcul configurée pour mettre en œuvre un procédé selon l'une des revendications précédentes.

**10.** Réseau de bord de véhicule comportant une unité de calcul selon la revendication 9.

**11.** Programme informatique comportant des moyens de code de programme qui permettent à une unité de calcul de mettre en œuvre un procédé selon l'une des revendications 1 à 8, lorsqu'ils sont exécutés sur l'unité de calcul, en particulier selon la revendication 9.

**12.** Support de mémoire lisible par machine ayant un programme informatique enregistré sur celui-ci qui comporte des moyens de code de programme qui permettent à une unité de calcul de mettre en œuvre un procédé selon l'une des revendications 1 à 8, lorsqu'ils sont exécutés sur l'unité de calcul.

Fig. 1

# Fig. 2

# Fig. 3

# Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012217116

**In der Beschreibung aufgeführte Nicht-Patentliteratur**

- **CHAKRABARTI et al.** A current reconstruction algorithm for three-phase inverters using integrated current sensors in the low-side switches. IEEE, 2003, 925-932